# EUROPÄISCHE PATENTANMELDUNG

(11) **EP 4 810 649 A1**
(43) Veröffentlichungstag der Anmeldung: **23.09.2026**
(21) Anmeldenummer: 25165338.2
(22) Anmeldetag: 21.03.2025
(51) Int. Cl.: C23C 14/04, C23C 14/06, C23C 14/22, C23C 14/24, H10N 52/01, H10N 52/85, H10N 60/01

(54) **VERFAHREN UND VORRICHTUNG ZUR HERSTELLUNG EINER NANOSTRUKTUR UND ZUGEHÖRIGE STRUKTUR**

(71) Anmelder: Forschungszentrum Jülich GmbH, 52428 Jülich (DE)
(72) Erfinder: SCHÜFFELGEN, Peter, 53115 Bonn (DE); VAßEN-CARL, Max, 52066 Aachen (DE); GRÜTZMACHER, Detlev, 52382 Niederzier (DE)
(74) Vertreter: Gille Hrabal Partnerschaftsgesellschaft mbB Patentanwälte

(57) **Zusammenfassung**

Offenbart wird ein Verfahren und eine Vorrichtung zur Herstellung einer Struktur durch Materialabscheidung auf einem Substrat sowie eine resultierende Struktur. Bei dem Verfahren wird auf einem Substrat (10) mittels einer Schattenmaske (15) abgeschieden, um mindestens einen Bereich (11) zu begrenzen, an dem Quellmaterial abgeschieden wird, wobei eine weitere Maske (16) verwendet werden kann, um mindestens den Bereich (11) zu begrenzen, an dem Quellmaterial abgeschieden wird. Das Verfahren umfasst ein Bewegen eines ersten Quellmaterials mittels einer ersten Materialquelle (6) durch die Schattenmaske (15) und Abscheiden des ersten Quellmaterials in dem Bereich (11), wobei die erste Materialquelle (6) in einer ersten Position (21) relativ zum Substrat (10) angeordnet ist, und ein Bewegen eines zweiten Quellmaterials mittels einer zweiten Materialquelle (7), gegebenenfalls durch die weitere Maske (16), und Abscheiden des zweiten Quellmaterials in dem Bereich (11), wobei die zweite Materialquelle (7) in einer von der ersten Position abweichenden zweiten Position (22) relativ zum Substrat (10) angeordnet ist. Es können somit auch Materialien abgeschieden werden, die mit herkömmlichen Verfahren nicht selektiv abgeschieden werden können, beispielsweise ein magnetischer topologischer Isolator wie CrBiSbTe für Hall- oder Majorana-Bauelemente.

## Beschreibung

Die Erfindung betrifft ein Verfahren und eine Vorrichtung zur Herstellung einer Struktur, z. B. einer Nanostruktur, durch Materialabscheidung auf einem Substrat, sowie eine Struktur. Es wird durch Abscheidung von Quellmaterialien ein neues Material erzeugt, das aus mindestens zwei unterschiedlichen Arten von Atomen aufgebaut ist und deshalb im Folgenden als Verbundmaterial bezeichnet wird. Verbundmaterial im Sinne der Erfindung meint demnach kein Kompositwerkstoff. Ein Verbundmaterial im Sinne der Erfindung kann Bereiche aus verschiedenen Materialien umfassen, etwa eine Schichtfolge, oder homogen sein.

Zur Herstellung von Nanostrukturen kann zunächst durch Wachsen ein flächiger Film hergestellt werden, der anschließend per Lithografie strukturiert wird. Dadurch wird allerdings die Qualität der Seitenflächen verringert.

Die Publikation WO 2018 171 823 A1 betrifft das selektive Wachstum bzw. Abscheiden von Majorana-Materialien und die Kombination derselben mit Supraleitern. Hierbei wird einerseits eine erste Maske für ein strukturiertes Aufbringen des Majorana-Materials und andererseits eine weitere Maske für das strukturierte Wachstum eines supraleitenden Materials erzeugt und verwendet. Das strukturierte Aufbringen des Majorana-Materials und des supraleitenden Materials erfolgt ohne Unterbrechung in einer inerten Atmosphäre. Selektives oder strukturiertes Wachstum meint Wachstum nur an bestimmten Stellen.

Dieses Verfahren hat jedoch den Nachteil, dass es nicht für alle Quellmaterialien bzw. Quellmaterialkombinationen verwendet werden kann. Beispielsweise ist die Legierung und/oder Dotierung von topologischen Isolatoren, z. B. mit Übergangsmetallen, mit dem beschriebenen Verfahren nicht möglich, da aufgrund des hohen Haftungskoeffizienten der Übergangsmetalle kein selektives Wachstum bzw. Abscheiden der Legierung auf dem Substrat möglich ist. Auch die Verbindung mehrerer Quellmaterialien ist nur möglich, wenn die unter den jeweiligen Bedingungen einschlägigen Abscheidetemperaturen dieser Quellmaterialien in einem ähnlichen Bereich liegen.

Es ist die Aufgabe der Erfindung, ein verbessertes Verfahren zur Herstellung von Strukturen, eine zugehörige Vorrichtung sowie eine weiterentwickelte Struktur zur Verfügung zu stellen. Insbesondere soll ein selektives Abscheiden auch für Quellmaterialien ermöglicht werden, bei denen dies bisher bislang nicht möglich war.

Die Aufgabe wird gelöst durch das Verfahren gemäß Anspruch 1 und die Struktur gemäß dem nebengeordneten Anspruch. Vorteilhafte Ausgestaltungen sind in den Unteransprüchen angegeben.

Zur Lösung der Aufgabe dient ein Verfahren zur Herstellung einer Struktur durch Abscheidung von Quellmaterial auf einem Substrat. Es wird eine Schattenmaske verwendet, um mindestens einen Bereich zu begrenzen, an dem Quellmaterial abgeschieden wird. Es wird in einer Ausgestaltung eine weitere Maske verwendet, um mindestens einen Bereich zu begrenzen, beispielsweise den Bereich, an dem Quellmaterial abgeschieden wird. Das Verfahren kann umfassen ein Bewegen eines ersten Quellmaterials mittels einer ersten Materialquelle zu dem Bereich unter Verwendung der Schattenmaske und insbesondere Abscheiden des ersten Quellmaterials in dem Bereich. Die erste Materialquelle kann in einer ersten Position relativ zum Substrat angeordnet sein. Das erste Quellmaterial kann auch durch eine weitere Maske bewegt werden. Das Verfahren kann ferner umfassen ein Bewegen eines zweiten Quellmaterials mittels einer zweiten Materialquelle zu dem Bereich, in einer Ausgestaltung unter Verwendung der weiteren Maske, und insbesondere Abscheiden des zweiten Quellmaterials in dem Bereich. Die zweite Materialquelle kann in einer von der ersten Position abweichenden zweiten Position relativ zum Substrat angeordnet sein.

Auf diese Weise können auch Quellmaterialien, die mittels einer weiteren Maske allein nicht selektiv gewachsen werden können, wie z. B. (magnetische) Übergangsmetalle am selektiven Wachstum teilnehmen. Es wird ein selektives Abscheiden, insbesondere Wachstum, von Quellmaterialien ermöglicht, insbesondere innerhalb eines z. B. durch die Maske geometrisch definierten Bereichs, bei denen das mit herkömmlichen Verfahren nicht möglich war. Es ist nicht nötig, Quellmaterialien zu wählen, die bei einer bestimmten Abscheidetemperatur selektiv auf dem Substrat, nicht jedoch auf einer Maske abgeschieden werden. Die Quellmaterialien sind insbesondere unterschiedliche Materialien. Es kann grundsätzlich jedes Material verwendet werden, das auf geeignete Weise in eine Gasphase überführt oder verdampft und anschließend abgeschieden werden kann. Zudem ist es möglich, zwei oder mehr unterschiedliche Materialien zu kombinieren. Besonders vorteilhaft ist die Verwendung der Schattenmaske in Kombination mit der weiteren Maske.

Beim selektiven Wachstum wird das abgeschiedene Quellmaterial typischerweise unmittelbar in Kristallform abgelagert.

Insbesondere wird eine Anlage verwendet, die es erlaubt, verschiedene Quellmaterialien individuell zu verdampfen, beispielsweise eine Anlage zur Molekularstrahlepitaxie oder TLE (Thermal Laser Epitaxie). Die Anlage kann mehrere Zellen umfassen, die als Materialquelle für die unterschiedlichen Quellmaterialien dienen. Die Anlage umfasst typischerweise eine Kammer, in der die Struktur hergestellt werden kann bzw. innerhalb derer die Abscheidung erfolgt. Eine Materialquelle setzt Quellmaterial frei, insbesondere gasförmiges Quellmaterial, welches nach der Bewegung, insbesondere im gasförmigen Zustand, an der Oberfläche des Substrats angelagert wird bzw. wächst, insbesondere in fester Form. Dies wird als Abscheidung bezeichnet. Die Bewegung von der Quelle zu der Abscheideposition kann als ballistische Bewegung bezeichnet werden. Das Quellmaterial kann z. B. ein elementares Material sein, insbesondere ein Metall, oder eine Legierung.

Die Schattenmaske (engl.: stencil mask) ist ein insbesondere flächiges Element mit typischerweise wenigstens einer Aussparung, insbesondere Öffnung, auch Fenster genannt. Die Aussparung ist durchgehend, so dass Quellmaterial die Schattenmaske passieren kann, um abgeschieden zu werden. Alternativ oder ergänzend kann auch ein Rand der Schattenmaske die Fläche, auf der Material abgeschieden wird, begrenzen. Insbesondere wirkt die Maske durch Schattenwurf. Mit anderen Worten wird die Bewegung des Quellmaterials durch die Aussparungsbereiche und/oder an den Rändern vorbei ermöglicht, während die Bewegung des ersten Quellmaterials in den nicht ausgesparten Bereichen blockiert wird. Eine Aussparung kann am Rand der Schattenmaske sein. Eine Öffnung ist dagegen im Inneren, also eingerahmt von dem Material der Schattenmaske. Die Schattenmaske wird insbesondere durch Ätzen strukturiert. Mit anderen Worten werden Aussparungen und/oder Öffnungen durch Ätzen erzeugt. Mehrere benachbarte Bereiche von Schattenmasken können zusammenwirken und zwischen einander einen Freiraum lassen, der wie eine Öffnung wirkt. Zusammenwirkende Schattenmasken können auf unterschiedlichen Ebenen liegen, also unterschiedliche Abstände zum Substrat aufweisen. Das Bewegen des ersten Quellmaterials zu dem Bereich unter Verwendung der Schattenmaske kann demnach eine Bewegung durch die Schattenmaske, insbesondere durch eine Öffnung oder Aussparung in der Schattenmaske, und/oder eine Bewegung an einem Rand einer oder mehrerer Schattenmasken vorbei sein. Die Schattenmaske ist insbesondere temperaturbeständig bis mindestens 500 °C, insbesondere bis mindestens 800 °C, bevorzugt bis mindestens 1000 °C, besonders bevorzugt bis 1200 °C.

Das Verfahren dient insbesondere der Herstellung einer Mikrostruktur oder einer Nanostruktur, beispielsweise eines Bauteils mit einer Erstreckung und/oder zumindest einem Formelement im Mikrometer-Bereich bzw. im Nanometer-Bereich. Das Verfahren kann dazu verwendet werden, aus mehreren unterschiedlichen Quellmaterialien ein gewünschtes Verbundmaterial herzustellen. Das Verfahren kann beispielsweise zur Herstellung einer dotierten und/oder legierten Struktur verwendet werden. Die Struktur kann Bereiche enthalten, an denen Material vorhanden ist und Bereiche, an denen kein Material vorhanden ist. Insbesondere sind die Quellmaterialien unterschiedlich. Es ist jedoch nicht ausgeschlossen, dass zwei oder mehr Quellmaterialien gleich sind.

In einer Ausführungsform ist das Substrat ein Nichtleiter oder ein Halbleiter. Insbesondere ist das Substrat bei tiefen Temperaturen ein Nichtleiter oder ein Halbleiter, beispielsweise bei Supraleiter-Anwendungen. Auf diese Weise können Transportexperimente durchgeführt werden, ohne dass Strom durch das Substrat fließen könnte. Beispielsweise ist das Substrat Silicium, GaAs, CdTe oder Saphir. Das Substrat hat insbesondere eine zu der herzustellenden Struktur passende Kristallstruktur. In einer anderen Ausführungsform ist das Substrat ein elektrisch leitfähiges und/oder niederohmiges Substrat. Dies ist beispielswiese für STM-Anwendungen (Scanning Tunneling Microscope - Rastertunnelmikroskop) vorteilhaft. In einer Ausführungsform wird mit dem Verfahren ein supraleitendes Material auf ein topologisches Material, insbesondere ein Majorana-Material, aufgetragen. Ein supraleitendes Material kann als Kontakt verwendet werden.

Insbesondere erfolgt das Abscheiden des ersten Quellmaterials und das Abscheiden des zweiten Quellmaterials, Teile des Verfahrens oder das gesamte Verfahren in einem Vakuum, beispielsweise ein Ultrahochvakuum (p ≤ 1 × 10⁻⁷ mbar, vorzugsweise p ≤ 1 × 10⁻¹¹ mbar), und/oder in einer inerten Atmosphäre durchgeführt. Insbesondere werden Schritte des Verfahrens, beispielsweise alle Schritte, durchgeführt, ohne das Vakuum bzw. die inerte Atmosphäre zu unterbrechen. Als eine inerte Atmosphäre wird beispielsweise reines N₂ oder Argon angesehen.

Insbesondere umfasst das Verfahren ferner, dass das zweite Quellmaterial in dem Bereich, in dem das erste Quellmaterial abgeschieden wird, am selektiven Wachstum teilnimmt. Insbesondere nimmt das zweite Quellmaterial in allen anderen Bereichen, in denen das erste Quellmaterial aufgrund der Schattenmaske nicht abgeschieden wird, nicht an einem selektiven Wachstum teil.

In einer Ausgestaltung wird ein magnetisches Verbundmaterial hergestellt, insbesondere ein magnetischer topologischer Isolator.

Es kann eine magnetische Struktur hergestellt werden. Es kann eine Struktur aus oder mit mehreren Bereichen hergestellt werden, von denen zumindest einer magnetische Eigenschaften aufweist. Ein magnetischer topologischer Isolator kann beispielsweise CrBiSbTe umfassen oder daraus hergestellt sein, beispielsweise (Cr_{y}BiₓSb₁₋ₓ)₂Te₃. Es kann ein Josephson-Kontakt hergestellt werden, etwa umfassend das genannte Material, ggf. in Kombination mit supraleitenden Kontakten.

In einer Ausführungsform wird nach Abscheidung der Quellmaterialien aus den abgeschiedenen Quellmaterialien ein Verbundmaterial hergestellt. Das Verbundmaterial kann ein magnetisches Verbundmaterial sein. Das Verbundmaterial kann z. B. ein funktionales Material sein, welches supraleitend, magnetisch, topologisch und/oder dielektrisch sein kann.

In einer Ausführungsform werden das erste Quellmaterial und zumindest ein weiteres Quellmaterial derart kombiniert, beispielsweise durch chemische Reaktion, dass eine Struktur aus einem gewünschten Verbundmaterial entsteht.

In einer Ausführungsform wird eine Lage eines oder mehrerer Quellmaterialien abgeschieden. Es kann sich um eine Monolage handeln, bei der einzelne Teilchen wie Atome oder Moleküle in einer Schicht nebeneinander vorliegen. Hierbei entspricht die Schichtdicke dem Durchmesser eines Teilchens. Alternativ oder ergänzend kann die Lage wenige Atomlagen umfassen und/oder dünner sein als ein nm.

In einer Ausgestaltung nimmt das zweite Quellmaterial insbesondere unter Verwendung der weiteren Maske unter definierten Abscheidebedingungen an einem selektiven Wachstum teil. Dies kann durch Co-Evaporation erfolgen. Bei der Co-Evaporation kann eine Kristallstruktur direkt während des Abscheidens entstehen. Insbesondere werden zwei Quellmaterialien zumindest zeitabschnittsweise zeitgleich abgeschieden und es wird zeitgleich die entstehende Kristallstruktur gewachsen. Insbesondere nimmt das zweite Quellmaterial am selektiven Wachstum teil.

Beispielsweise wird die Temperatur so eingestellt, dass eine Abscheidung des zweiten Quellmaterials auf dem Substrat erfolgt, aber keine Abscheidung auf der weiteren Maske erfolgt. Beispielsweise wird eine Temperatur oberhalb einer Grenztemperatur eingestellt, so dass keine Abscheidung auf der weiteren Maske erfolgt. Unterhalb der Grenztemperatur würde demnach auch auf der Maske eine Abscheidung erfolgen.

Das zweite Quellmaterial ist demnach insbesondere ein Quellmaterial, das unter bestimmten Abscheidebedingungen am selektiven Wachstum teilnehmen kann. Das erste Quellmaterial ist dahingehend nicht beschränkt und kann hingegen ein beliebiges Material sein, welches auf geeignete Weise in eine Gasphase überführt oder verdampft und anschließend abgeschieden werden kann, insbesondere unter Verwendung einer Anlage zur Molekularstrahlepitaxie.

In einer Ausgestaltung werden das erste Quellmaterial und das zweite Quellmaterial zumindest zeitabschnittsweise zeitgleich abgeschieden. Es gibt also zumindest einen Zeitabschnitt, in dem eine zeitgleiche Abscheidung beider Quellmaterialien erfolgt. Insbesondere erfolgt der Start der Abscheidung und/oder das Ende der Abscheidung der zwei Quellmaterialien gleichzeitig.

Insbesondere werden die zwei Quellmaterialien derart abgeschieden, dass sie beim und/oder nach dem Abscheiden gemeinsam eine gewünschte Kristallstruktur bilden. Dabei kann eine Mischung der Quellmaterialien und/oder eine chemische Reaktion zwischen den Quellmaterialien erfolgen. Der Ort der Abscheidung ist durch die Ausgestaltung und relative Position der entsprechenden weiteren Maske und/oder Schattenmaske in Bezug zu der Abscheideposition oder den Abscheidepositionen definiert.

In einer Ausgestaltung wird das erste Quellmaterial in einem ersten Winkel zu einer Oberfläche des Substrats bewegt. In einer Ausgestaltung wird das zweite Quellmaterial in einem vom ersten Winkel unterschiedlichen zweiten Winkel zu der Oberfläche des Substrats bewegt. Insbesondere ist ein Azimutwinkel beim ersten Quellmaterial anders als beim zweiten Quellmaterial. Typischerweise ist ein Polarwinkel bzw. ein Winkel zur Substratoberfläche bzw. Abscheidungsoberfläche dagegen gleich. Auch dieser Winkel kann allerdings unterschiedlich sein.

Insbesondere sind die Winkel derart, dass das zweite Quellmaterial von der Schattenmaske unbehelligt auf das Substrat bewegt werden kann. Die Schattenmaske befindet sich mit anderen Worten nicht auf dem Weg zwischen der zweiten Materialquelle und dem Substrat. Das erste Quellmaterial wird dann beispielsweise schräg zur Oberfläche des Substrats bewegt. Die Schattenmaske befindet sich typischerweise zwischen der ersten Materialquelle und dem Substrat. Das erste Quellmaterial kann ebenso durch die weitere Maske hindurch bewegt werden. Die unterschiedlichen Positionen der zwei Materialquelle wird durch unterschiedliche Winkel realisiert. Mit anderen Worten gelangen die unterschiedlichen Quellmaterialien aus unterschiedlichen Richtungen auf dieselbe Stelle.

Diese Ausgestaltung erlaubt eine besonders einfache Abscheidung auch von Quellmaterialien, bei denen das selektive Wachstum mittels einer weiteren Maske nicht möglich ist.

Beispielsweise weichen der erste Azimutwinkel und der zweite Azimutwinkel um wenigstens 10°, insbesondere um wenigstens 20°, voneinander ab.

In einer Ausgestaltung wird eine magnetische Phase oder ein magnetisches Verbundmaterial hergestellt, insbesondere ein magnetischer topologischer Isolator.

In einer Ausgestaltung ist eine Entfernung der Schattenmaske vom Substrat größer als eine Entfernung der weiteren Maske vom Substrat, insbesondere um einen Faktor von wenigstens 3, bevorzugt wenigstens 5 und besonders bevorzugt wenigstens 20. Der Abstand wird gemessen von der Oberfläche der jeweiligen Maske zur Oberfläche des Substrats. Die weitere Maske kann das Substrat direkt kontaktieren oder auf einer das Substrat kontaktierende Stützschicht aufliegen. In diesem Fall entspricht der Abstand der Dicke der weiteren Maske. Das erste Quellmaterial wird also bezogen auf die Substratoberfläche auf einer höheren Ebene bzw. einer weiter vom Substrat entfernten Ebene selektiv blockiert als das zweite Quellmaterial. Auf diese Weise kann die Aufgabe besonders vorteilhaft gelöst werden.

Die Entfernung der Schattenmaske vom Substrat ist die lichte Weite zwischen der dem Substrat zugewandten Oberfläche der Schattenmaske und der der Schattenmaske zugewandten Oberfläche des Substrats. Die Entfernung liegt typischerweise im Bereich zwischen 300nm und 5µm. Die Schattenmaske wird typischerweise von stützenden Säulen vom Substrat beabstandet gehalten. Dadurch kann die Schattenmaske lokal freistehend sein.

Insbesondere ist die Dicke der Schattenmaske größer als die Dicke der weiteren Maske, bevorzugt um einen Faktor von mindestens 5 oder mindestens 50, in einigen Beispielen mindestens 80 oder mindestens 100. Die erste Maske und die zweite Maske können aus demselben oder unterschiedlichen Materialien hergestellt sein.

In einer Ausgestaltung weisen die Schattenmaske und die weitere Maske einander entsprechende Strukturen auf und/oder sind einander entsprechend in Bezug zum Substrat ausgerichtet.

Die Strukturierungen der beiden Masken entsprechen einander zumindest abschnittsweise. Das bedeutet, dass zumindest eine und bevorzugt mehrere Begrenzungen von Aussparungen vorhanden sind, die einander entsprechen. Somit können das erste Quellmaterial und das zweite Quellmaterial mit einer engen Begrenzung an derselben Position abgeschieden werden. Beispielsweise enthalten die Schattenmaske und die weitere Maske eine oder mehrere einander entsprechende Öffnungen.

Die Schattenmaske und die weitere Maske können einander entsprechend in Bezug zum Substrat ausgerichtet sein. Ausgehend von einer Position auf der Oberfläche des Substrats befinden sich eine Begrenzung der Schattenmaske sowie die erste Materialquelle auf einer ersten geraden Linie. Ausgehend von derselben Position auf der Oberfläche des Substrats befinden sich eine der Begrenzung der Schattenmaske entsprechende Begrenzung der weiteren Maske sowie die zweite Materialquelle auf einer zweiten geraden Linie. Die zwei Linien sind typischerweise nicht parallel, sondern winklig zueinander ausgerichtet.

Die einander entsprechende Ausrichtung kann durch Einstellen des benötigten seitlichen Versatzes der zwei Masken sowie der Dicke und/oder Höhenposition der Schattenmaske über dem Substrat erfolgen. Es kann so sichergestellt werden, dass das erste Quellmaterial lediglich durch die Aussparungen der ersten Maske hindurch auf den Bereich des Substrats gelangt, wo eine Abscheidung erwünscht ist.

In einer Ausgestaltung werden mehrere unterschiedliche zweite Quellmaterialien zeitgleich durch die weitere Maske abgeschieden.

Es können, wie in herkömmlichen Verfahren, mehrere unterschiedliche Quellmaterialien abgeschieden werden, deren Abscheidetemperaturen ausreichend ähnlich sind. Das erste Quellmaterial kann beispielsweise ein Quellmaterial sein, dessen Abscheidetemperatur außerhalb des notwendigen Ähnlichkeitsbereich ist. Dieses Quellmaterial könnte mit herkömmlichen Techniken nicht am selektiven Wachstum teilnehmen.

In einer Ausgestaltung wird ein weiteres Quellmaterial unter Verwendung der Schattenmaske abgeschieden. Dies kann vor der Abscheidung, nach der Abscheidung und/oder zumindest zeitabschnittsweise zeitgleich mit der Abscheidung erfolgen. Beispielsweise kann ein strukturierter Normalleiter oder Supraleiter aufgetragen werden. Die Abscheidung des weiteren Quellmaterials erfolgt insbesondere nach Beendigung der Abscheidungen der ersten, zweiten, ggf. dritten und ggf. vierten und ggf. weiteren Quellmaterialien. So wird auf die hergestellte Struktur bzw. Phase eine weitere Struktur bzw. Phase aufgebracht.

Wie die Schattenmaske ist auch die weitere Maske ein insbesondere flächiges Element mit typischerweise wenigstens einer Aussparung, insbesondere Öffnung, auch Fenster genannt. Die Aussparung ist durchgehend, so dass Quellmaterial die weitere Maske passieren kann, um abgeschieden zu werden. Alternativ oder ergänzend kann auch ein Rand der weiteren Maske die Fläche, auf der Material abgeschieden wird, begrenzen. Insbesondere wirkt die Maske durch Abschirmung. Mit anderen Worten wird die Bewegung des ersten Quellmaterials durch die Aussparungsbereiche und/oder an den Rändern vorbei ermöglicht, während die Bewegung des Quellmaterials in den nicht ausgesparten Bereichen blockiert wird. Eine Aussparung kann am Rand der weiteren Maske sein. Eine Öffnung ist dagegen im Inneren, also eingerahmt von dem Material der weiteren Maske. Die weitere Maske ist insbesondere direkt auf dem Substrat oder nah am Substrat angeordnet. Die weitere Maske wird insbesondere durch Ätzen strukturiert. Mit anderen Worten werden Aussparungen und/oder Öffnungen durch Ätzen erzeugt. Mehrere benachbarte Bereiche von weiteren Masken können zusammenwirken und zwischen einander einen Freiraum lassen, der wie eine Öffnung wirkt. Das Bewegen des zweiten Quellmaterials zu dem Bereich unter Verwendung der weiteren Maske kann demnach eine Bewegung durch die weiteren Maske, insbesondere durch eine Öffnung oder Aussparung in der weiteren Maske, und/oder eine Bewegung an einem Rand einer oder mehrerer weiterer Masken vorbei sein.

Die weitere Maske kann zwei Schichten umfassen. Eine erste Schicht kann direkt auf dem Substrat aufliegen. Die erste Schicht kann zum Beispiel SiO₂umfassen oder daraus bestehen. Die erste Schicht kann eine Dicke von mindestens 1 nm, bevorzugt mindestens 3 nm, und/oder höchstens 20 nm, bevorzugt höchstens 10 nm aufweisen.

Die erste Schicht kann zum Stützen einer zweiten Schicht dienen. Die zweite Schicht kann auf der ersten Schicht aufliegen. Die zweite Schicht kann zum Beispiel Si₃N₄ umfassen oder daraus bestehen. Die zweite Schicht kann dazu dienen, eine selektive Abscheidung von Material zu ermöglichen. Die zweite Schicht kann eine Dicke von mindestens 10 nm, insbesondere mindestens 20 nm, und/oder höchstens 50 nm, insbesondere höchstens 30 nm aufweisen. Insbesondere ist die erste Schicht dicker als die zweite Schicht. Die weitere Maske umfasst grundsätzlich mindestens die zweite Schicht. Eine erste Schicht ist nicht unbedingt notwendig. Es kann eine erste Strukturierung in der weiteren Maske erzeugt werden, insbesondere durch beide Schichten hindurch und/oder durch Ätzen.

Die Schattenmaske kann zwei Schichten umfassen. Eine erste Schicht kann direkt auf der weiteren Maske aufliegen, also beispielsweise auf der zweiten Schicht der weiteren Maske. Die erste Schicht der Schattenmaske kann zum Beispiel SiO₂ umfassen oder daraus bestehen. Eine zweite Schicht der Schattenmaske kann auf der ersten Schicht aufliegen. Die zweite Schicht kann zum Beispiel Si₃N₄ umfassen oder daraus bestehen. Die erste Schicht kann eine Dicke von mindestens 20 nm, insbesondere mindestens 0,3 µm und/oder höchstens 5 µm, insbesondere höchstens 20 µm oder 50 µm, aufweisen. Die zweite Schicht kann eine Dicke von mindestens 100 nm, insbesondere höchstens 50 nm und/oder höchstens 5µm, insbesondere höchstens 500 nm, insbesondere etwa 200 nm aufweisen. Insbesondere ist die erste Schicht dicker als die zweite Schicht.

Es kann eine der ersten Strukturierung der weiteren Maske entsprechende zweite Strukturierung in der Schattenmaske erzeugt werden, insbesondere durch beide Schichten hindurch und/oder durch Ätzen. Die zweite Strukturierung ist dabei typischerweise versetzt gegenüber der ersten Strukturierung angeordnet und/oder dient der Herstellung derselben Struktur auf dem Substrat wie die erste Strukturierung. Es kann zudem eine dritte Strukturierung in der Schattenmaske erzeugt werden, insbesondere durch beide Schichten hindurch und/oder durch Ätzen. Die dritte Strukturierung ist insbesondere versetzt gegenüber der ersten und/oder zweiten Strukturierung angeordnet. Die dritte Strukturierung dient insbesondere der Herstellung einer weiteren, zusätzlichen Struktur auf dem Substrat. Auf diese Weise können Kontakte und/oder Elektroden hergestellt werden.

Es kann ein Ätzen der so hergestellten Strukturierung erfolgen, um Stützen herzustellen, beispielsweise mit Fluorwasserstoffsäure, beispielsweise in einer Konzentration von 1%.

Diese Säure hat eine hohe Selektivität von SiO₂ zu Si₃N₄. Dadurch werden die jeweiligen zweiten Schichten aus Si₃N₄ unterätzt. Es verbleiben Stützen. Diese zuvor definierten bzw. angelegten Stützen sind dabei so groß, dass eine Oxidsäule verbleibt. Auf diese Weise kann die ansonsten freistehende Strukturierung auf ihrer Höhe und Position gehalten werden. Alternativ können beliebige andere geeignete Materialien für Stützen und/oder Schattenmaske verwendet werden, z. B. amorphes Silizium, a-Si, als Material für Stützen. In dem Fall kann etwa mit Xenondifluorid geätzt werden, ohne die Schattenmaske anzugreifen.

Es kann ein Positionieren des so vorbereiteten Substrats mitsamt der Schattenmaske und der weiteren Maske in einer Kammer zur Abscheidung, z. B. einer Molekularstrahlepitaxie-Anlage, erfolgen. Es kann eine Ausrichtung des Substrats mitsamt der Masken erfolgen, um ein erstes Quellmaterial durch die Schattenmaske hindurch zu bewegen und abzuscheiden.

In einem Ausführungsbeispiel wird ein erfindungsgemäßes Verfahren verwendet, um eine Struktur, beispielsweise einen Nano-Hallbarren, aus CrBiSbTe herzustellen. Als Substrat wird Silizium, insbesondere hochohmiges Silizium (111), oder Saphir verwendet. Es wird das oben beschriebene Verfahren verwendet, wobei die weitere Maske aus 5 nm SiO₂ und 25 nm Si₃N₄ aufgebaut wird. Die Schattenmaske wird aus 0,3 µm bis 5 µm SiO₂ und 200 nm Si₃N₄ aufgebaut. Es wird mit 1% Fluorwasserstoffsäure geätzt. Zeitgleich werden Cr, Bi, Sb und Te abgeschieden, wobei Cr unter Verwendung der Schattenmaske abgeschieden wird. Bi, Sb und Te werden nicht unter Verwendung der Schattenmaske abgeschieden. Es wird eine geeignete Abscheidungstemperatur eingestellt. So kann ein Hallbarren in-situ hergestellt werden. Anschließend kann beispielsweise eine Kontaktierung mittels Pt erfolgen, insbesondere ebenfalls in-situ. Anschließend kann beispielsweise eine Abdeckung mit Al₂O₃ erfolgen, insbesondere ebenfalls in-situ.

In einem anderen Ausführungsbeispiel wird ein oder mehrere Majorana-Materialien hergestellt und/oder es wird ein Baustein für ein Majorana-Qubit hergestellt. Es werden beispielsweise drei Nanoribbons gewachsen, insbesondere aus CrBiSbTe. Die drei Nanoribbons können T-förmig zueinander ausgerichtet hergestellt werden. Die Nanoribbons können mit einem oder mehreren Supraleitern bedeckt werden, wodurch lokalisierte Majorana Nullmoden an den jeweiligen Enden hergestellt werden, die miteinander interagieren können.

Ein Majorana-Material gemäß der vorliegenden Erfindung ist ein Material, in dem Majorana-Nullmoden entstehen, sobald man diese Materialien in Kontakt mit einem Supraleiter bringt und die zur Erzeugung der MZMs (Majorana zero modes; Majorana-Nullmoden) notwendigen Felder (E-Feld und B-Feld) anlegt. Majorana-Materialien sind beispielsweise Diracmaterialien, welche sich wiederum in beispielhaft topologische Isolatoren und Weyl-Metalle unterteilen lassen, sowie "half-metals", welche nicht zu verwechseln sind mit Halbmetallen (engl. semimetals), sowie III-V-Halbleiter Nanodrähte. Notwendigerweise besitzen Majorana-Materialien fermionische Zustände, die keinen Spin-Freiheitsgrad besitzen (in der englischen Sprache und im weiteren Verlauf dieses Dokuments werden diese Zustände als "spinless fermions" bezeichnet). In einer Teilmenge der Majorana-Materialien, den sogenannten topologischen Isolatoren (Tls), führt beispielsweise die Spin-Bahn-Wechselwirkung im Festkörper dazu, dass für fermionische Zustände an der Oberfläche des TIs die Richtung des Spins an die Bewegungsrichtung des Elektrons gekoppelt ist.

Es können auch abweichende Quellmaterialien verwendet werden. Beispielsweise kann Cr durch Mn, V oder Fe ersetzt werden. Diese Materialien sind unter den typischen praktischen Bedingungen typischerweise nicht mit selektivem Wachstum kompatibel. Diese Materialien können erfindungsgemäß gleichzeitig und/oder nacheinander abgeschieden werden. Kompatibilität mit selektivem Wachstum im Sinne der Erfindung gilt in Bezug zu den typischen praktischen Bedingungen. Die Temperatur beträgt typischerweise mindestens -270°C, insbesondere mindestens 100 °C und/oder höchstens 3000 °C, insbesondere höchstens 500 °C.

Die Voraussetzung für selektives Wachstum besteht insbesondere darin, dass in dem Bereich, in dem Material wachsen soll, innerhalb eines Temperaturfensters das Absorptions- zu Desorptionsverhältnis der abzuscheidenden Quellmaterialien groß genug ist, um das Wachstum eines Kristalls zu ermöglichen. Während in den angrenzenden Bereichen, wo kein Wachstum stattfinden soll, das Adsorptions- zu Desorptionsverhältnis der benutzten Quellmaterialien so klein ist, dass dort kein Material auf dem Substrat oder auf der weiteren Maske abgeschieden wird, trotz nominal identischer/gleicher Temperatur des Heizelements zum Heizen des Substrats. In anderen Worten führt ein Unterschied in der anzutreffenden Oberflächenbeschaffenheit zwischen Substrat und Bereichen, an denen das Substrat durch eine Schattenmaske oder eine weitere Maske bedeckt ist dazu, dass ein Kristall auf dem Substrat wächst, nicht jedoch auf einer der genannten Masken.

Kompatibilität mit selektivem Wachstum kann auch abhängen von den weiteren Quellmaterialien. Das oder die nicht im selben Temperaturfenster selektiv abscheidbare Quellmaterial oder Quellmaterialien ist in den Bedingungen dann nicht kompatibel mit selektivem Wachstum.

In einer Ausgestaltung wird nach dem Abscheiden des ersten Quellmaterials, des zweiten Quellmaterials und ggf. weiterer Quellmaterialien das hergestellte Verbundmaterial umhüllt. Insbesondere erfolgt das Umhüllen mit einer undurchlässigen Schicht. Das Umhüllen erfolgt insbesondere so, dass keine ungewünschten Stoffe, insbesondere Gase, zum Verbundmaterial gelangen können. Das Umhüllen erfolgt insbesondere, bevor das Verbundmaterial mit einem Gas, insbesondere einem nicht inerten Gas, in Kontakt kommt. Das Umhüllen erzeugt eine Passivierungsschicht.

Die undurchlässige Schicht ist insbesondere undurchlässig für Sauerstoff. Die undurchlässige Schicht ist insbesondere gasdicht. Die undurchlässige Schicht kann Siliziumnitrid oder Al₂O₃ umfassen oder daraus hergestellt sein. Die undurchlässige Schicht kann aus einer Gasphase abgeschieden worden sein. Die undurchlässige Schicht kann mit derselben Methode abgeschieden werden wie das erste und/oder zweite Quellmaterial. Die undurchlässige Schicht kann unter Rotation, insbesondere des Substrats, typischerweise um die z-Achse, aufgebracht werden. Die undurchlässige Schicht kann aufgetragen werden, während ein abgeschiedenes Material von der weiteren Maske, dem Substrat und/oder einem weiteren abgeschiedenen Material begrenzt ist. Die undurchlässige Schicht ist insbesondere dünn. Beispielsweise beträgt die Dicke der undurchlässigen Schicht weniger als 50 nm, bevorzugt weniger als 10 nm, insbesondere weniger als 3 nm. Die undurchlässige Schicht verhindert einen Alterungsprozess des Verbundmaterials, auch als "Aging" bezeichnet, bei dem Fremdatome sich in das Verbundmaterial einlagern.

In einer Ausführungsform wird mit dem Verfahren eine Struktur, insbesondere eine Nanostruktur, aus BiSbTe hergestellt. Dies erfolgt insbesondere unter Verwendung der weiteren Maske. Dies erfolgt insbesondere durch selektives Wachstum bezeichnet (engl.: "selective area growth", SAG). In einer Ausführungsform wird mit dem Verfahren die Struktur legiert und/oder dotiert, insbesondere mit einem Quellmaterial wie z. B. Cr. Das Quellmaterial ist insbesondere nicht kompatibel mit selektivem Wachstum wie etwa mit der weiteren Maske. Würde Cr gemeinsam mit Bi, Sb und Te abgeschieden, wäre ein selektives Wachstum nicht mehr möglich, da das Verbundmaterial CrBiSbTe überall und nicht mehr selektiv abgeschieden würde. Für dieses Quellmaterial, z. B. Cr, wird deshalb die Schattenmaske verwendet. Die Schattenmaske dient dazu, dass das Quellmaterial, hier Cr, nur dorthin gelangt, wo es abgeschieden werden soll oder nicht stört. Die Schattenmaske dient als Filter für das nicht mit selektivem Wachstum kompatible Quellmaterial. Die Schattenmaske ist insbesondere weiter vom Substrat beabstandet als die weitere Maske.

Sowohl das Herstellen der Struktur als auch das Dotieren können gemeinsam, also z. B. zeitgleich und/oder in einer Aufspannung erfolgen. Es ist möglich, das nicht mit selektivem Wachstum kompatible Quellmaterial in die selektive Abscheidung integriert werden.

Die selektive Abscheidung erfolgt insbesondere wie in Druckschrift WO 2018 171 823 A1 mittels der dort als "erste Maske 2, 3" bezeichneten Maske, die der weiteren Maske der vorliegenden Erfindung entspricht. Die Öffnung für das nicht selektiv wachsbare Material kann dabei, wie etwa in Figur 3 der genannten Druckschrift dargestellt, in die obere Maske integriert werden. Alternativ kann die Öffnung in eine zusätzliche, dritte maskierende Schicht integriert sein.

In einer Ausgestaltung umfasst das Verfahren ferner Bewegen eines dritten Quellmaterials mittels einer dritten Materialquelle durch die Schattenmaske. Das Verfahren umfasst insbesondere Abscheiden des dritten Quellmaterials, bevorzugt in dem Bereich. Insbesondere ist die dritte Materialquelle beim Abscheiden in der dritten Position relativ zum Substrat angeordnet. Das Abscheiden des dritten Quellmaterials kann vor, nach und/oder zeitgleich zum Abscheiden des ersten und/oder zweiten Quellmaterials erfolgen, insbesondere zumindest zeitabschnittsweise zeitgleich.

In einem Ausführungsbeispiel sind die weitere Maske und die Schattenmaske so ausgestaltet und angeordnet, dass sie Abscheidung der jeweiligen Quellmaterialien auf deckungsgleichen Bereichen ermöglichen. In einem Ausführungsbeispiel sind die weitere Maske und die Schattenmaske so ausgestaltet und angeordnet, dass sie Abscheidung der jeweiligen Quellmaterialien auf nicht deckungsgleichen Bereichen ermöglichen. Beispielsweise kann nur ein Bereich einer hergestellten Struktur dotiert werden, wie etwa die Spitze eines Nanodrahtes. Eine Öffnung in der oberen Maske oder Schattenmaske kann dafür nur eine Teilfläche der Öffnung in der unteren Maske oder weiteren Maske darstellen. Es können mehrere Öffnungen genutzt werden, um gleichzeitig verschiedene Bereiche mit verschiedenen Quellmaterialien zu dotieren.

In einer Ausgestaltung umfasst das Verfahren ferner Bewegen eines vierten Quellmaterials mittels einer vierten Materialquelle durch die Schattenmaske. Das Verfahren umfasst insbesondere Abscheiden des vierten Quellmaterials, bevorzugt in dem Bereich. Insbesondere ist die vierte Materialquelle beim Abscheiden in der vierten Position relativ zum Substrat angeordnet. Das Abscheiden des vierten Quellmaterials kann vor, nach und/oder zeitgleich zum Abscheiden des ersten, zweiten und/oder dritten Quellmaterials erfolgen, insbesondere zumindest zeitabschnittsweise zeitgleich.

In einer Ausgestaltung wird ferner eine Abschirmungsstruktur verwendet, um einen Teil des Bereichs abzuschirmen, so dass kein Quellmaterial auf dem Teil des Bereichs abgeschieden wird. Die Abschirmungsstruktur ist separat von der Maske und der Schattenmaske. Die Abschirmungsstruktur kann beispielsweise beim Herstellen von Funktionalmaterial, etwa für Elektroden bzw. Kontakte verwendet werden, auf dem Teil des Bereichs das entsprechende Material gezielt nicht abzuscheiden. So kann etwa eine Trennung der Elektroden bzw. Kontakte erzeugt werden.

Ein weiterer Aspekt der Erfindung ist eine Vorrichtung zur Herstellung einer Struktur durch Abscheidung von Quellmaterial auf einem Substrat. Die Vorrichtung umfasst insbesondere eine Haltevorrichtung zum Halten eines Substrats. Die Vorrichtung umfasst insbesondere eine erste Materialquelle zur Freisetzung eines abzuscheidenden ersten Quellmaterials. Insbesondere kann die erste Materialquelle in einer ersten Position relativ zu dem mittels der Haltevorrichtung gehaltenen Substrat angeordnet werden. Insbesondere umfasst die Vorrichtung eine zweite Materialquelle zur Freisetzung eines abzuscheidenden zweiten Quellmaterials. Insbesondere kann die zweite Materialquelle in einer von der ersten Position abweichenden zweiten Position relativ zu dem mittels der Haltevorrichtung gehaltenen Substrat angeordnet werden. Insbesondere umfasst die Vorrichtung eine Schattenmaske zur Begrenzung mindestens eines Bereichs zur Abscheidung von Quellmaterial bzw. eines Bereichs, an welchem Quellmaterial abgeschieden wird. Insbesondere umfasst die Vorrichtung eine weitere Maske zur Begrenzung mindestens des Bereichs zur Abscheidung von Quellmaterial bzw. des Bereichs, an welchem Quellmaterial abgeschieden wird. Die weitere Maske kann einen Bereich begrenzen, der kleiner, gleich groß oder größer ist als der Bereich, der von der Schattenmaske begrenzt wird. Alle Merkmale, Vorteile und Eigenschaften des eingangs beschriebenen Verfahrens können ebenso für die Vorrichtung gelten und umgekehrt. Insbesondere umfasst die Vorrichtung ferner entsprechende Einrichtungen zur Durchführung weiterer beschriebener Verfahrensschritte und -merkmale.

Ein weiterer Aspekt der Erfindung ist eine Struktur, insbesondere eine Mikro- oder Nanostruktur, die mit dem erfindungsgemäßen Verfahren herstellbar oder hergestellt sein kann. Insbesondere umfasst die Struktur ein Verbundmaterial. In einer Ausgestaltung umfasst die Struktur eine erste Phase, die mindestens ein erstes Quellmaterial umfasst. Insbesondere ist das erste Quellmaterial nicht kompatibel mit selektivem Wachstum. Insbesondere ist das erste Quellmaterial nicht kompatibel mit einem herkömmlichen selektivem Wachstum, welches ohne eine Schattenmaske gemäß der vorliegenden Erfindung auskommt. Insbesondere ist das erste Quellmaterial unter Verwendung einer Schattenmaske abgeschieden worden. In einer Ausgestaltung umfasst die Struktur eine zweite Phase, die ein zweites Quellmaterial und insbesondere ferner ein drittes Quellmaterial, ggf. ein viertes Quellmaterial, beispielsweise ein fünftes Quellmaterial und optional ein oder mehrere weitere Quellmaterialien umfasst. Insbesondere sind diese Quellmaterialien kompatibel mit selektiver Abscheidung bzw. selektivem Wachstum und bevorzugt mittels selektiver Abscheidung abgeschieden bzw. gewachsen worden. Das erste Quellmaterial umfasst insbesondere Cr, Fe, Mn und/oder V. Alle Merkmale, Vorteile und Eigenschaften des eingangs beschriebenen Verfahrens sowie der Vorrichtung können ebenso für die Struktur gelten und umgekehrt.

In einer Ausführungsform ist die Grenzfläche zwischen der ersten Phase und der zweiten Phase kontaminationsfrei. Mit anderen Worten befinden sich dort keinerlei Verunreinigungen. Dann weist die an die Grenzfläche angrenzende erste Phase keine Verunreinigungen auf und die an die Grenzfläche angrenzende zweite Phase weist keine Verunreinigungen auf. Bevorzugt befinden sich dort keine Sauerstoffatome, keine anderen Atome von Gasen und/oder überhaupt keine Fremdatome. Dies wird erst durch das erfindungsgemäße Verfahren möglich, da durch die Herstellung unmittelbar hintereinander keinerlei Kontakt mit anderen Stoffen erfolgt. Bevorzugt ist die Grenzfläche epitaktisch. Unter einem epitaktischen Aufwachsen wird insbesondere verstanden, dass auf einer kristallinen Phase eine weitere kristalline Phase abgeschieden wird, wobei mindestens eine kristallographische Orientierung der abgeschiedenen weiteren kristallinen Phase einer Orientierung der kristallinen Schicht der kristallinen Phase entspricht. Also entspricht insbesondere mindestens eine kristallographische Orientierung der zweiten Phase einer Orientierung der ersten Phase. Insbesondere ist die erste Phase an der Grenzfläche kristallin und/oder die zweite Phase ist an der Grenzfläche kristallin. Es liegt damit eine geordnete Gitterstruktur vor.

Eine Phase meint ein zusammenhängendes, insbesondere homogenes Volumen eines Materials, beispielsweise eines Verbundmaterials oder eines Quellmaterials, insbesondere in kristalliner Form.

Die Struktur ist insbesondere eine Hybridstruktur. Die Struktur kann wenigstens ein strukturiertes Majorana-Material und insbesondere wenigstens ein darauf angeordnetes supraleitendes Material umfassen. Erfindungsgemäß kann die Herstellung auch andersherum erfolgen. So kann zunächst ein supraleitendes Material hergestellt werden, insbesondere durch selektives Wachstum durch die Schattenmaske, bevorzugt selektives Wachstum, und anschließend ein Majorana-Material darauf gewachsen werden. Die Struktur kann eine Passivierungsschicht umfassen. Insbesondere weist die Struktur, typischerweise das strukturierte Majorana-Material eine drahtförmige Ausgestaltung auf, und/oder eine Ausgestaltung mit einer Länge von mindestens 0,1 und/oder höchstens 100 µm, einer Breite von mindestens 10 und/oder höchstens 500 nm und/oder einer Schichtdicke von mindestens 0,2 nm, vorzugsweise mindestens 5 nm und/oder höchstens 260 nm, vorzugsweise höchstens 50 nm, auf. Insbesondere ist eine Grenzfläche zwischen dem strukturierten Majorana-Material und wenigstens einem darauf angeordneten supraleitenden Material kontaminationsfrei. Insbesondere ist die Oberfläche des strukturierten Majorana-Materials vollständig abgedeckt ist, und zwar durch ein Material, welches eine native Oxidationsschicht auszubilden vermag, ein supraleitendes Material und/oder eine Passivierungsschicht.

In einer Ausgestaltung ist die Struktur vollständig umhüllt, insbesondere mit einer undurchlässigen Schicht, einem Substrat und/oder einer weiteren Maske. Eine erste Seite, die während des Abscheidens oben liegen kann, kann vom Substrat bedeckt sein. Das Substrat ist insbesondere undurchlässig. Seitliche Flächen, insbesondere alle umlaufenden seitlichen Flächen, kann zumindest teilweise von der weiteren Maske bedeckt sein. Dies ist jedoch nicht unbedingt erforderlich. Die weitere Maske kann zumindest teilweise und/oder bereichsweise undurchlässig sein. Alle weiteren Oberflächen der ersten Phase und der zweiten Phase und ggf. jeder weiteren Phase, falls vorhanden, können von einer undurchlässigen Schicht bedeckt sein. Die undurchlässige Schicht entspricht insbesondere der oben beschriebenen Umhüllung. Insbesondere ist die Struktur vollständig gekapselt, so dass keine ungewünschten Stoffe, insbesondere Gase, zu den jeweiligen Phasen gelangen können.

Nachfolgend werden Ausführungsbeispiele der Erfindung auch anhand von Figuren näher erläutert. Merkmale der Ausführungsbeispiele können einzeln oder in einer Mehrzahl mit den beanspruchten Gegenständen kombiniert werden, sofern nichts Gegenteiliges angegeben ist. Die beanspruchten Schutzbereiche sind nicht auf die Ausführungsbeispiele beschränkt.

Es zeigen:
- Figuren 1 bis 3:: Schritte zur Herstellung einer Maske, sowie
- Figuren 4 bis 5:: schematische Darstellungen unterschiedlicher erfindungsgemäßer Verfahren.

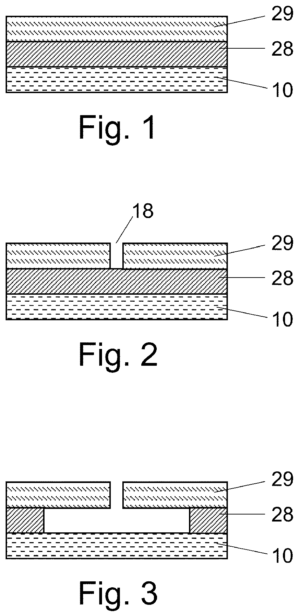

Die Figuren 1 bis 3 zeigen in Schnittzeichnungen Schritte zur Herstellung einer Maske auf einem Substrat 10. Die Maske kann eine Schattenmaske oder eine weitere Maske sein. Die Schichtdicken sind nicht maßstabsgetreu, es handelt sich vielmehr um rein schematische Darstellungen.

In Figur 1 ist auf einer durchgehenden Substratschicht, beispielsweise aus Saphir oder Silizium, z. B. Si(111), eine durchgehende erste Schicht 28 ausgebildet, beispielsweise aus SiO₂. Die erste Schicht kann eine Dicke zwischen 500 nm und 1000 nm aufweisen, z. B. ungefähr 750 nm. Auf der ersten Schicht 28 ist eine durchgehende zweite Schicht 29 ausgebildet, beispielsweise aus Si₃N₄. Die zweite Schicht kann eine Dicke zwischen 100 nm und 200 nm aufweisen, beispielsweise ungefähr 120 nm.

Es werden die gewünschten Strukturen in die zweite Schicht 29 eingebracht, beispielsweise durch Ätzen. Figur 2 zeigt rein beispielhaft eine Öffnung 18 in der zweiten Schicht. Anschließend wird ein freistehender Teil der Maske freigelegt durch Entfernung dazwischenliegender Bereiche der ersten Schicht 28, hier des SiO₂, z. B. durch Ätzen mit Fluorwasserstoffsäure. Es verbleiben Säulen, hier aus SiO₂, die die zweite Schicht 29 am Substrat 10 halten, wie in Figur 3 dargestellt.

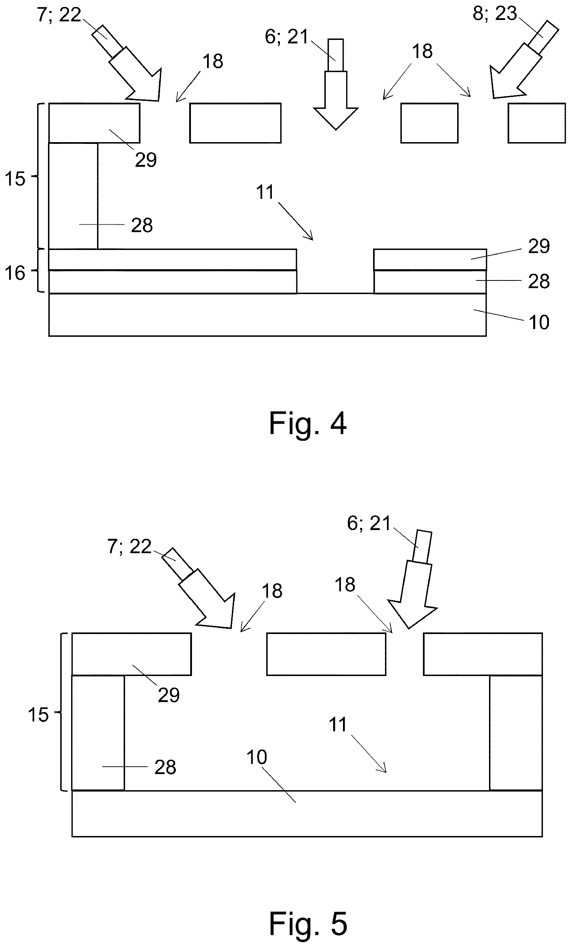

Figur 4 zeigt ein erfindungsgemäßes Verfahren zur Herstellung einer Nanostruktur. Es sind eine erste Materialquelle 6 und eine zweite Materialquelle 7 vorhanden.

Auf dem Substrat ist eine weitere Maske 16 vorhanden. Diese umfasst zwei Schichten 28, 29, die beispielsweise analog zu den zwei Schichten 28, 29 der Schattenmaske aus Figur 3 aufgebaut sein kann. Es ist beispielhaft eine Öffnung 18 in der weiteren Maske 16 vorhanden, durch die der Bereich 11 des Substrats 10, auf dem Quellmaterial abgeschieden werden soll, freiliegt.

Auf der weiteren Maske 16 ist eine Schattenmaske 15 vorhanden. Diese umfasst zwei Schichten 28, 29, die beispielsweise analog zu den zwei Schichten 28, 29 der Schattenmaske aus Figur 3 aufgebaut sein kann. Die Schichtdicken sind insbesondere größer als bei der weiteren Maske 16. Die erste Schicht 28 kann beispielsweise aus Stützen oder Säulen bestehen. Es sind beispielhaft drei Öffnungen 18 in der Schattenmaske 16 vorhanden, um Quellmaterial passieren zu lassen.

Die erste Materialquelle 6 befindet sich in einer ersten Position 21, beispielsweise senkrecht über dem Bereich 11. Das erste Quellmaterial kann so in der mit dem Pfeil angezeigten Richtung senkrecht zur Oberfläche des Substrats 10 zum Bereich 11 bewegt werden, und zwar durch die Öffnung 18 in der Schattenmaske 15 sowie durch die Öffnung 18 in der weiteren Maske 16. Auf diese Weise kann beispielsweise ein Quellmaterial abgeschieden werden, welches durch Einstellen einer definierten Temperatur selektiv auf dem Substrat, nicht jedoch auf der weiteren Maske 16 abgeschieden werden kann, wie es beispielsweise aus der Publikation WO 2018 171 823 A1 bekannt ist.

Eine der Öffnung 18 der weiteren Maske entsprechende Öffnung 18 ist auf der links dargestellten Seite in der Schattenmaske 15 angeordnet. Die zweite Materialquelle 22 befindet sich auf der zweiten Position 22. Zweites Quellmaterial kann somit entlang der mit dem Pfeil angezeigten, hier beispielhaft schräg nach rechts weisenden Richtung durch diese entsprechende Öffnung 18 in der Schattenmaske zum Bereich 11 bewegt werden und beispielsweise gleichzeitig mit dem ersten Quellmaterial dort abgeschieden werden. Das zweite Quellmaterial kann beispielsweise ein Quellmaterial sein, welches nicht dazu geeignet ist, auf bekannte Weise bei einer definierten Temperatur selektiv auf dem Substrat abgeschieden zu werden. Die Schattenmaske 15 ermöglicht ein Aufbringen von Quellmaterial lediglich an den Aussparungen oder Öffnungen.

Optional ist eine dritte Materialquelle 8 vorhanden, mit der ein weiteres Quellmaterial abgeschieden werden kann. Die dritte Materialquelle 23 befindet sich auf einer rechts gezeigten dritten Position 23. Ein weiteres Quellmaterial kann somit entlang der mit dem Pfeil angezeigten, hier beispielhaft schräg nach links zeigenden Richtung durch diese entsprechende Öffnung 18 in der Schattenmaske zum Bereich 11 bewegt werden und beispielsweise gleichzeitig mit dem ersten und/oder zweiten Quellmaterial dort abgeschieden werden. Alternativ oder ergänzend kann das weitere Quellmaterial z. B. nach der Abscheidung des ersten und/oder zweiten Quellmaterials abgeschieden werden. Das weitere Quellmaterial kann ein Quellmaterial sein, welches nicht dazu geeignet ist, auf bekannte Weise bei einer definierten Temperatur selektiv auf dem Substrat abgeschieden zu werden. Es kann aber auch ein zur derartigen selektiven Abscheidung geeignetes Quellmaterial verwendet werden. Die Schattenmaske 15 ermöglicht auch in diesem Fall ein Aufbringen von Quellmaterial lediglich an den Aussparungen oder Öffnungen.

Aus einer oder mehreren ersten Materialquellen 6 können beispielsweise Bi, Sb und Te zur Abscheidung freigesetzt werden. Diese Quellmaterialien können unter Verwendung der weiteren Maske 16 selektiv gewachsen werden. Aus der zweiten Materialquelle 2 kann beispielsweise Cr zur Abscheidung freigesetzt werden. Cr-Atome können durch die Schattenmaske 16 blockiert werden, so dass sie selektiv nur an dem Bereich 11 auftreffen. Aus der dritten Materialquelle 3 kann beispielsweise ein Metall und/oder ein Supraleiter zur Abscheidung freigesetzt werden.

Als zweite Materialquelle 6 kann eine Materialquelle zur Abgabe eines oder mehrerer Quellmaterialien dienen. Als zweite Materialquelle 6 kann beispielsweise eine Vorrichtung mit mehreren Materialquellen vorgesehen sein, die in einem Kreisbogen oder Kreis angeordnet sind. Es können dann nacheinander unterschiedliche Materialquellen verwendet werden, um unterschiedliche Quellmaterialien nacheinander abzuscheiden. Davor, zeitgleich und/oder danach können durch die Materialquellen 7 und ggf. 8 ein oder mehrere Quellmaterialien abgeschieden werden. So können die beschriebenen Verfahren kombiniert werden.

Figur 5 zeigt ein anderes erfindungsgemäßes Verfahren. Hierbei ist auf dem Substrat lediglich eine Schattenmaske 15 erzeugt worden. Diese umfasst zwei Schichten 28, 29, die beispielsweise analog zu den zwei Schichten 28, 29 der Schattenmaske aus Figur 3 aufgebaut sein kann. Die erste Schicht 28 ist typischerweise säulenförmig aufgebaut. Der säulenförmige Aufbau hat den Vorteil, dass ein ausreichender Abstand von der Oberfläche des Substrats 10 bis zur zweiten Schicht 29 besteht, um die Abscheidung aus unterschiedlichen Positionen 21, 22 zu ermöglichen. Auch hier sind beispielhaft zwei Öffnungen 18 in der Schattenmaske 16 vorhanden, um Quellmaterial passieren zu lassen. Es ist in diesem Beispiel keine weitere Maske vorhanden.

Die erste Materialquelle 6 befindet sich in einer ersten Position, die sich nicht genau senkrecht, sondern etwas schräg über dem Bereich 11 des Substrats 10 befindet, an dem abgeschieden werden soll. Die zweite Materialquelle 7 befindet sich ähnlich wie in Figur 4 auf der linken Seite. Beispielsweise können am Ort der zweiten Materialquelle 7 mehrere Materialquellen befinden, die beispielsweise Cr, Bi, Sb und Te nacheinander abscheiden. Dies kann mit der Technik gemäß den Figuren 6 bis 10 realisiert sein. Beispielsweise kann die erste Materialquelle 6 zur Freisetzung eines Metalls oder Supraleiters eingerichtet sein. So kann auf besonders einfache Weise und ohne Herstellung einer selektiv wirkenden weiteren Maske beispielsweise eine Nanostruktur in Form eines oder mehrerer CrBiSbTe-Kristalle hergestellt werden.

**Bezugszeichenliste**

| | |
|---|---|
| Erstes Quellmaterial | 1 |
| Zweites Quellmaterial | 2 |
| Drittes Quellmaterial | 3 |
| Viertes Quellmaterial | 4 |
| Verbundmaterial | 5 |
| Erste Materialquelle | 6 |
| Zweite Materialquelle | 7 |
| Dritte Materialquelle | 8 |
| Vierte Materialquelle | 9 |
| Substrat | 10 |
| Bereich | 11 |
| Schattenmaske | 15 |
| Weitere Maske | 16 |
| Öffnung | 18 |
| Abscheidungsposition | 20 |
| Erste Position | 21 |
| Zweite Position | 22 |
| Dritte Position | 23 |
| Relativbewegung | 27 |
| Erste Schicht | 28 |
| Zweite Schicht | 29 |
| Haltevorrichtung | 30 |

## Patentansprüche

1. Verfahren zur Herstellung einer Struktur durch Abscheidung von Quellmaterial (1, 2) auf einem Substrat (10), wobei eine Schattenmaske (15) verwendet wird, um mindestens einen Bereich (11) zu begrenzen, an dem Quellmaterial (1, 2) abgeschieden wird, mit den Schritten:
- Bewegen eines ersten Quellmaterials (1) mittels einer ersten Materialquelle (6) zu dem Bereich (11) unter Verwendung der Schattenmaske (15) und Abscheiden des ersten Quellmaterials (1) in dem Bereich (11), wobei die erste Materialquelle (6) in einer ersten Position (21) relativ zum Substrat (10) angeordnet ist,
- Bewegen eines zweiten Quellmaterials (2) mittels einer zweiten Materialquelle (7) zu dem Bereich und Abscheiden des zweiten Quellmaterials (2) in dem Bereich (11), wobei die zweite Materialquelle (7) in einer von der ersten Position (21) abweichenden zweiten Position (22) relativ zum Substrat (10) angeordnet ist.

2. Verfahren nach dem vorhergehenden Anspruch, wobei eine weitere Maske (16) verwendet wird, um mindestens den Bereich (11) zu begrenzen, an dem Quellmaterial (1, 2) abgeschieden wird, wobei das zweite Quellmaterial unter Verwendung der weiteren Maske (16) abgeschieden wird.

3. Verfahren nach dem vorhergehenden Anspruch, wobei das zweite Quellmaterial (2) insbesondere unter Verwendung der weiteren Maske (16) unter definierten Abscheidebedingungen an einem selektiven Wachstum teilnimmt.

4. Verfahren nach einem der vorhergehenden Ansprüche, wobei das erste Quellmaterial (1) und das zweite Quellmaterial (2) zumindest zeitabschnittsweise zeitgleich abgeschieden werden.

5. Verfahren nach einem der vorhergehenden Ansprüche, wobei eine magnetische Phase oder ein magnetisches Verbundmaterial hergestellt wird, insbesondere ein magnetischer topologischer Isolator.

6. Verfahren nach einem der vier vorhergehenden Ansprüche, wobei eine Entfernung der Schattenmaske (15) vom Substrat (10) größer ist als eine Entfernung der weiteren Maske (16) vom Substrat (10), insbesondere um einen Faktor von wenigstens 5.

7. Verfahren nach einem der fünf vorhergehenden Ansprüche, wobei die Schattenmaske (15) und die weitere Maske (16) einander entsprechende Strukturen aufweisen und einander entsprechend in Bezug zum Substrat (10) ausgerichtet sind.

8. Verfahren nach einem der sechs vorhergehenden Ansprüche, wobei mehrere unterschiedliche zweite Quellmaterialien (2) zeitgleich durch die weitere Maske (16) abgeschieden werden.

9. Verfahren nach einem der vorhergehenden Ansprüche, wobei ein weiteres Quellmaterial unter Verwendung der Schattenmaske (15) abgeschieden wird.

10. Verfahren nach einem der vorhergehenden Ansprüche, ferner umfassend:
- Bewegen eines dritten Quellmaterials (3) mittels einer dritten Materialquelle (8) durch die Schattenmaske (15) und Abscheiden des dritten Quellmaterials (3) in dem Bereich (11), wobei die dritte Materialquelle in der dritten Position (23) relativ zum Substrat angeordnet ist.

11. Verfahren nach dem vorhergehenden Anspruch, ferner umfassend:
- Bewegen eines vierten Quellmaterials (4) mittels einer vierten Materialquelle (9) durch die Schattenmaske (15) und Abscheiden des vierten Quellmaterials (4) in dem Bereich (11), wobei die vierte Materialquelle in der vierten Position (24) relativ zum Substrat angeordnet ist.

12. Verfahren nach einem der vorhergehenden Ansprüche, **dadurch gekennzeichnet, dass** nach dem Abscheiden des ersten Quellmaterials (1), des zweiten Quellmaterials (2) und ggf. weiterer Quellmaterialien (3, 4) das hergestellte Verbundmaterial mit einer undurchlässigen Schicht umhüllt wird.

13. Verfahren nach einem der vorhergehenden Ansprüche, wobei ferner eine Abschirmungsstruktur verwendet wird, um einen Teil des Bereichs (11) abzuschirmen, so dass kein Quellmaterial auf dem Teil des Bereichs (11) abgeschieden wird.

14. Vorrichtung zur Herstellung einer Struktur durch Abscheidung von Quellmaterial (1, 2) auf einem Substrat (10), umfassend
- eine Haltevorrichtung (30) zum Halten eines Substrats (10),
- eine erste Materialquelle (6) zur Freisetzung eines abzuscheidenden ersten Quellmaterials (1), wobei die erste Materialquelle (6) in einer ersten Position (21) relativ zu dem mittels der Haltevorrichtung (30) gehaltenen Substrat (10) angeordnet werden kann,
- eine zweite Materialquelle (7) zur Freisetzung eines abzuscheidenden zweiten Quellmaterials (2), wobei die zweite Materialquelle (7) in einer von der ersten Position (21) abweichenden zweiten Position (22) relativ zu dem mittels der Haltevorrichtung (30) gehaltenen Substrat (10) angeordnet werden kann,
- eine Schattenmaske (15) zur Begrenzung mindestens eines Bereichs (11), an welchem Quellmaterial (1, 2) abgeschieden wird, und/oder
- eine weitere Maske (16) zur Begrenzung mindestens des Bereichs (11), an welchem Quellmaterial (1, 2) abgeschieden wird.

15. Struktur, insbesondere Mikro- oder Nanostruktur, herstellbar nach einem Verfahren gemäß einem der vorhergehenden Ansprüche, umfassend eine erste Phase, die mindestens ein erstes Quellmaterial umfasst, und eine zweite Phase, die mindestens ein zweites Quellmaterial umfasst, wobei eine Grenzfläche zwischen der ersten Phase und der zweiten Phase kontaminationsfrei ist, wobei das erste Quellmaterial nicht kompatibel mit selektivem Wachstum ist.
